# EUROPÄISCHE PATENTSCHRIFT

(11) **EP 3 022 813 B1**
(45) Veröffentlichungstag und Bekanntmachung des Hinweises auf die Patenterteilung: **12.04.2017**
(21) Anmeldenummer: 14752283.3
(22) Anmeldetag: 15.07.2014
(51) Int. Cl.: H02G 15/113, H02G 15/103, H02G 3/06, H02G 15/013, H02G 15/117, H02G 15/16, H01R 4/18, H01R 4/02, B60R 16/03, H02G 3/08, H02G 15/007

(54) **ELEKTRISCHER LEISTUNGSVERTEILER FÜR EIN ELEKTRO- ODER HYBRIDFAHRZEUG SOWIE VERTEILERGEHÄUSE FÜR EINEN DERARTIGEN LEISTUNGSVERTEILER**
ELECTRICAL POWER DISTRIBUTOR FOR AN ELECTRIC OR HYBRID VEHICLE AND DISTRIBUTOR HOUSING FOR SUCH A POWER DISTRIBUTOR
RÉPARTITEUR DE PUISSANCE ÉLECTRIQUE POUR VÉHICULE ÉLECTRIQUE OU HYBRIDE AINSI QUE BOÎTIER DE RÉPARTITEUR POUR UN TEL RÉPARTITEUR DE PUISSANCE

(30) Priorität: 17.07.2013 DE 102013011874
(43) Veröffentlichungstag der Anmeldung: 25.05.2016
(73) Patentinhaber: LEONI Bordnetz-Systeme GmbH, 97318 Kizingen (DE)
(72) Erfinder: KETT, Alexander, 92706 Luhe-Wildenau (DE); ALBERT, Volker, 97337 Dettelbach (DE); HAUSCHILD, Wolfgang, 90513 Zirndorf (DE); DEHN, Christian, 91227 Leinburg (DE)
(74) Vertreter: FDST Patentanwälte
(86) Internationale Anmeldenummer: PCT/EP2014/065172
(87) Internationale Veröffentlichungsnummer: WO 2015/007744

(56) Entgegenhaltungen:
- EP-A1- 2 463 959
- DE-A1- 10 222 820
- DE-U1- 9 017 029
- GB-A- 2 104 306
- US-A- 5 306 870
- Martin Hopf: "Hochvolt Leistungsverteiler für Hybrid-und Elektrofahrzeuge", , November 2012 (2012-11), XP055161531, Gefunden im Internet: URL:http://www.leoni-electromobility.com/f ileadmin/bu/emo/news/121199_Elektronikprax is_HV-Verteilerbox.pdf [gefunden am 2015-01-13]
- Dr. Jürgen Engbring: "Der Weg zum optimalen HV-Bordnetz", , Februar 2012 (2012-02), XP055161535, Gefunden im Internet: URL:http://www.leoni-electromobility.com/f ileadmin/bu/emo/fachartikel/120999_E-Mobil ity_Der-Weg-zum-optimalen-Bordnetz_final.p df [gefunden am 2015-01-13]

## Beschreibung

Die Erfindung betrifft einen elektrischen Leistungsverteiler für ein Elektro- oder Hybridfahrzeug mit den Merkmalen des Oberbegriffs des Anspruchs 1.

Ein derartiger Leistungsverteiler ist aus der US 5 306 870 A zu entnehmen. Dieser dient zur Verbindung zwischen verzweigten geschirmten Kabeln. Eine Schirmung des Kabels liegt zwischen einem Kabelmantel und einer Hülse ein. Diese weist eine umlaufende Nut auf, in die eine Wandung eines Gehäuses des Leistungsverteilers eingreift.

Weiterhin ist eine elektrische Kontaktierung von Schirmen an Gehäuse-durchführungen beispielsweise aus der DE 102 22 820 A1 oder der EP 2 463 959 A1 zu entnehmen.

Bei Elektro- oder Hybridfahrzeugen mit elektromotorischem Fahrantrieb werden mehrere Komponenten, darunter auch der Fahrmotor, mit einer Hochvolt-Spannung versorgt. Unter Hochvolt-Spannung werden hierbei Spannungswerte von einigen 100V, typischerweise beispielsweise im Bereich von 300V bis 600V verstanden.

In einem derartigen Kraftfahrzeug müssen daher mehrere verschiedene Hochvolt-Verbraucher über entsprechende Hochvolt-Versorgungsleitungen an die fahrzeugeigene Strom- bzw. Spannungsversorgung, üblicherweise ein Akkumulator, oder auch ein Generator, angeschlossen werden. Sind die anzuschließenden Komponenten weit von der Strom- bzw. Spannungsquelle entfernt, so sind lange Wege für die Versorgungsleitungen erforderlich. Diese sind aufgrund der hohen Spannungen und der entsprechend hohen Leistungen, die über sie übertragen werden, vergleichsweise kostenintensiv, schwer und benötigen zudem einen nicht unerheblichen Einbauraum.

Ausgehend hiervon liegt der Erfindung die Aufgabe zugrunde, in einem solchen Elektro- oder Hybridfahrzeug den Verkabelungsaufwand von derartigen Hochvolt-Versorgungsleitungen möglichst gering zu halten.

Die Aufgabe wird erfindungsgemäß gelöst durch einen elektrischen Hochvolt-Leistungsverteiler mit den Merkmalen des Anspruchs 1. Dieser ist bestimmungsgemäß bevorzugt in einem Elektro- oder Hybridfahrzeug mit einem elektromotorischen Fahrantrieb eingebaut. Der Leistungsverteiler weist dabei ein Verteilergehäuse mit einem Anschlussraum auf, in dem zumindest eine eingehende Versorgungsleitung an zumindest zwei abgehenden Versorgungsleitungen angeschlossen ist. Die Versorgungsleitungen sind dabei jeweils durch eine Gehäusedurchführung in den Anschlussraum eingeführt.

Im einfachsten Fall ist der Leistungsverteiler daher beispielsweise nach Art eines Y- oder auch T-Verteilers ausgebildet, welcher eine eingehende Versorgungsleitung an zwei ausgehenden Versorgungsleitungen anschließt. Alternative Ausgestaltungen mit mehr ein- und ausgehenden Versorgungsleitungen sind ebenfalls möglich. Grundsätzlich braucht nur ein Potential bzw. eine Ader, beispielsweise das positive Bezugspotential des Akkumulators, in den Leistungsverteiler eingeführt und auf die abgehenden Versorgungsleitungen aufgeteilt werden. Insbesondere im Kraftfahrzeugen wird ein Anschluss an das negative Bezugspotential häufig über eine anderweitige Masseanbindung erreicht. Alternativ besteht aber auch die Möglichkeit, dass in dem Leistungsverteiler zwei eingehende, isolierte Hochvolt-Adern beispielsweise für das positive sowie für das negative Bezugspotential jeweils auf die ausgehenden Versorgungsleitungen aufgeteilt werden.

Durch diesen insbesondere nach Art eines Y-Verteilers ausgebildeten Leistungsverteiler besteht daher die Möglichkeit, dezentral eine Hochvolt-Leitung aufzuteilen und damit unterschiedliche Komponenten zu versorgen. Hierdurch braucht beispielsweise von einem Heckbereich des Fahrzeugs nur eine Hochvolt-Versorgungsleitung in den Frontbereich geführt zu werden, bevor dort über den Leistungsverteiler die Versorgungsleitung auf zwei weitere Versorgungsleitungen aufgeteilt wird, um verschiedene Komponenten anzuschließen. Dadurch entfällt daher die doppelte Leitungsführung über das gesamte Kraftfahrzeug hinweg.

Grundsätzlich besteht auch die Möglichkeit, dass der Leistungsverteiler zur Aufteilung auf mehr als zwei Versorgungsleitungen ausgebildet ist. Das Grundprinzip bleibt das gleiche.

Aufgrund der hohen Spannungen sind die Hochvolt-Versorgungsleitungen mit einer Abschirmung versehen, um Störeinflüsse auf die Bordnetz-Elektronik zu vermeiden. Um eine konstruktiv einfache und zugleich robuste Abschirmung auch im Verbindungsbereich der eingehenden und abgehenden Versorgungsleitungen zu gewährleisten, ist erfindungsgemäß weiterhin das Verteilergehäuse zweiteilig aufgebaut und umfasst ein den Anschlussraum umgebendes und selbstragendes schalenartiges Innengehäuse aus zwei miteinander verbundenen Schalen aus einem elektrisch leitfähigem Material, so dass die Verbindungsstelle zwischen der eingehenden Versorgungsleitung und der abgehenden Versorgungsleitung EMVdicht ausgebildet ist. Weiterhin weist das Verteilergehäuse ein Außengehäuse aus einem elektrisch isolierenden Material auf. Dieses ist insbesondere zur Umwelt hin abgedichtet ausgebildet, so dass also keine Feuchtigkeit in den Anschlussraum eindringen kann, in dem die Aderenden der einzelnen Versorgungsleitungen zur wechselseitigen Verbindung freigelegt sind. Das Außengehäuse nimmt das Innengehäuse weiterhin schalenartig in sich auf. Das Innengehäuse liegt daher mit seinen Außenwandungen an den Innenwandungen des Außengehäuses vorzugsweise unmittelbar an. Die Konturen und Auswölbungen der beiden Gehäuse sind aneinander angepasst. Das Außengehäuse schmiegt sich daher vorzugsweise am Innengehäuse an und umschließt dieses vollumfänglich. Hierdurch wird eine zuverlässige Abdichtung gegenüber der Umwelt erzielt. Die beiden Gehäuse liegen daher schalenartig ineinander. Aufgrund der Abdichtung über das Außengehäuse braucht der Anschlussraum auch nicht zu Dichtzwecken vergossen werden. Beim Anschlussraum handelt es sich daher um einen freien, luftgefüllten Innenraum.

Eine jeweilige Abschirmung der Versorgungsleitungen ist zudem jeweils elektrisch leitend mit dem Innengehäuse verbunden. Über das Innengehäuse werden daher die Abschirmungen durchgehend ohne Unterbrechung miteinander verbunden. Über das elektrisch leitfähige Innengehäuse wird der Verbindungsbereich der Versorgungsleitungen zuverlässig elektrisch abgeschirmt. Durch die zweiteilige Ausgestaltung des Verteilergehäuses wird der besondere Vorteil erzielt, dass die zwei Funktionen der elektrischen Abschirmung sowie der Abdichtung zur Umwelt voneinander entkoppelt sind, so dass die beiden Gehäuse jeweils speziell im Hinblick auf ihre jeweilige Funktion ausgelegt werden können. Unter Innengehäuse wird hierbei jegliche Einhausung und Begrenzung des Anschlussraums verstanden, welche eine vollständige elektromagnetische Abschirmung des Anschlussraums bewirkt.

Im Hinblick auf eine zuverlässige elektrische Kontaktierung der Abschirmung mit dem Innengehäuse ist die Abschirmung zunächst mit einer Schirmhülsen-Baugruppe kontaktiert, welche ihrerseits wiederum mit dem Innengehäuse elektrisch verbunden ist. Über die Schirmhülsen-Baugruppe ist daher auf der einen Seite eine sichere und zuverlässige elektrische Verbindung zur Abschirmung der jeweiligen Versorgungsleitung sichergestellt und andererseits gleichzeitig eine zuverlässige elektrische Verbindung zu dem Innengehäuse, um die gewünschte durchgehende Abschirmung zu gewährleisten.

Die Schirmhülsen-Braugruppe ist in einer jeweiligen Gehäusedurchführung angeordnet, insbesondere eingeklemmt. Die Schirmhülsen-Baugruppe ist dabei insbesondere auf der zum Anschlussraum gewandten Seite des Dichtelements ausgebildet. Durch die Klemmung zwischen den Gehäuseschalen des Innengehäuses wird eine zuverlässige elektrische Verbindung gewährleistet. Dabei wird insbesondere die Schirmhülsen-Baugruppe auch etwas verformt. Vorzugsweise weist die Schirmhülsen-Baugruppe hierzu Kontaktfedern auf, die federnd gegen das Innengehäuse gepresst werden.

Im Bereich der Schirmhülsen-Baugruppe weist das Innengehäuse dabei jeweils einen Stutzen auf, durch den das Kabel geführt ist. Durch die Ausgestaltung als Stutzen ist eine bereichsweise radiale Klemmung der Schirmhülsen-Baugruppe gewährleistet.

Weiterhin umfasst die Schirmhülsen-Baugruppe eine Unterziehhülse sowie ein insbesondere als Crimpelement ausgebildetes Klemmelement, wobei die Abschirmung zwischen Unterziehhülse und Klemmelement eingeklemmt ist. Das Klemmelement ist daher wiederum als eine Hülse ausgebildet. Die Unterziehhülse ist dabei vorzugsweise zwischen dem Mantel und einem umgeschlagenen Teilbereich der Abschirmung angeordnet. Die Abschirmung selbst ist dann unmittelbar zwischen der Unterziehhülse und dem Klemmelement eingeklemmt.

Alternativ hierzu besteht auch die Möglichkeit, dass die Unterziehhülse zur Kontaktierung der Abschirmung stirnseitig in die Versorgungsleitung unter die Abschirmung eingeschoben wird und das Klemmelement außen auf den Mantel aufgeklemmt wird. Die Unterziehhülse bildet allgemein ein Gegenlager für das Klemmelement.

Durch die klemmende Anordnung der Schirmhülsen-Baugruppe in der jeweiligen Gehäusedurchführung erfährt die Baugruppe eine zumindest geringfügige Verformung.

Weiterhin ist die Schirmhülsen-Baugruppe in der jeweiligen Gehäusedurchführung axial unverschieblich und formschlüssig gehalten. Unter axialer Richtung wird hierbei die Einführrichtung, also die Längsrichtung der Gehäusedurchführung verstanden. Die formschlüssige Fixierung erfolgt dabei zwischen dem Innengehäuse und zumindest einer der beiden Hülsen, vorzugsweise die Crimphülse. Hierzu ist die Hülse an beiden Enden für einen in beide Richtungen wirkenden Formschluss radial aufgeweitet oder aufgebördelt. Die aufgebördelten Ränder stehen dabei in Axialrichtung über einen äußeren sowie über einen inneren Stirnrand der stutzenförmigen Gehäusedurchführung zur Ausbildung eines in beide Richtungen wirkenden Formschlusses über.

Im Hinblick auf eine möglichst robuste und einfache Ausgestaltung ist das Innengehäuse ein massives, mit durchgehenden Wandungen versehenes Gehäuse, insbesondere ein Blechgehäuse. Das Innengehäuse ist dabei selbsttragend und sorgt daher für die mechanische Stabilität des Verteilergehäuses insgesamt, oder trägt zumindest maßgeblich dazu bei. Vorzugsweise ist das Innengehäuse dabei als ein Blechbiege- , als ein Blechstanzbiegeteil oder als ein Tiefziehteil ausgebildet, so dass auch eine einfache und kostengünstige Herstellung gewährleistet ist. Alternativ zu der massiven Ausgestaltung ist das Innengehäuse zur Gewichtsreduktion mit Durchbrüchen versehen oder insgesamt nach Art eines Gitters, jedoch eigensteif und selbsttragend ausgebildet.

Bis auf die Gehäusedurchführungen in den Anschlussraum ist das Innengehäuse dabei zweckdienlicherweise vollständig geschlossen. Hierdurch ist eine gute EMV-Abschirmung erzielt.

Gemäß einer ersten bevorzugten Ausführungsvariante ist das Außengehäuse durch einen Umspritzvorgang ausgebildet. Unter Umspritzen wird dabei jegliches Einbetten des Innengehäuses in eine zunächst zumindest zähflüssige, formbare Masse verstanden, die aushärtet. "Umspritzen" umfasst daher insbesondere auch ein Umgießen. Das Innengehäuse ist daher in einem Spritz- oder Gussteil eingebettet, welches das Außengehäuse definiert. Das Innengehäuse bildet daher quasi die Negativform für das Außengehäuse.

Gemäß einer Alternativen Ausgestaltung ist das Außengehäuse als ein separates, eigenständiges Bauteil aus separat gefertigten und miteinander verbundenen Schalenteilen ausgebildet, welche um das Innengehäuse gelegt sind.

Im Hinblick auf eine einfache konstruktive Montage bestehen das Außengehäuse und/oder das Innengehäuse vorzugsweise jeweils aus zwei Halbschalen, die also eine gewölbte Struktur bilden und die zwischen sich den Anschlussraum einschließen. Bei den Halbschalen handelt es sich bevorzugt um Gleichteile, so dass also die Unter- und Oberschale insbesondere des Innengehäuses identisch sind. Auch bei der umspritzten Variante besteht das Innengehäuse aus zwei Halbschalen. Zweckdienlicherweise sind die Halbschalen dabei mit einem umlaufenden Rand ausgebildet, wobei der Rand des Innengehäuses vorzugsweise zwischen den Halbschalen des Außengehäuses und insbesondere zwischen den jeweiligen Rändern des Außengehäuses einliegen bzw. vom Spritzmaterial bei der umspritzten Variante eingefasst sind. Dadurch wird eine einfache Montage sowie eine zuverlässige Fixierung des Innengehäuses erzielt. Bei dem Außengehäuse handelt es sich vorzugsweise um ein eigensteifes Kunststoff-Gehäuse, welches ebenfalls selbsttragend ist.

Um eine dichte Einführung der einzelnen Versorgungsleitungen in den Anschlussraum zu gewährleisten, werden diese vorzugsweise abgedichtet durch die jeweilige Gehäusedurchführung hindurch geführt. Zweckdienlicherweise ist hierzu ein Dichtelement in die Gehäusedurchführung, insbesondere zwischen den Halbschalen des Verteilergehäuses eingelegt.

Alternativ zu einer unmittelbaren Abdichtung ist in einer bevorzugten Weiterbildung eine mittelbare Abdichtung ausgebildet, bei der eine Dichtungshülse mit darin einliegendem Dichtelement vorgesehen ist. Die Versorgungsleitung ist dabei durch das Dichtelement abgedichtet hindurch geführt. Die Dichtungshülse sorgt weiterhin für die Abdichtung zu der Innenwandung der Gehäusedurchführung. Hierdurch ist daher eine entkoppelte Abdichtung einerseits zu dem Außenumfang der jeweiligen Versorgungsleitung und andererseits zu der Innenwandung der jeweiligen Gehäusedurchführung durch die zwei separaten Teile Dichtungshülse und Dichtelement verwirklicht. Die Materialwahl, Dimensionierung etc. kann daher optimal auf die jeweiligen Werkstoffe, insbesondere den Kabelmantel der Versorgungsleitung einerseits und andererseits dem Metall der Gehäusedurchführungen abgestimmt werden. Dichtungshülse und Dichtelement sind daher vorzugsweise auch aus unterschiedlichen Materialien ausgebildet.

Zweckdienlicherweise ist die Dichtungshülse insgesamt in etwa topfförmig mit einem ringförmigen Hülsenboden und einem Hülsenmantel ausgebildet. In den durch den Hülsenmantel aufgespannten Raum liegt dabei das Dichtelement ein. An den ringförmigen Hülsenboden schließt sich vorzugsweise weiterhin ein Ringmantel an, welcher sich umfangsseitig dichtend an den Kabelmantel anlegt. Über die im Querschnitt betrachtete stufenförmige Ausgestaltung ist daher bereits durch die Dichtungshülse selbst eine Abdichtung sowohl zur Versorgungsleitung als auch zur Gehäusedurchführung erzielt. Gleichzeitig ist hierdurch ein Aufnahmeraum für das Dichtelement geschaffen.

Weiterhin umfasst die Schirmhülsen-Baugruppe vorzugsweise einen umlaufenden, ringförmigen Radialsteg, welcher das Dichtelement in Richtung zu einem Hülsenboden der Dichtungshülse einschließt. Dieser Radialsteg presst dabei beispielsweise das Dichtelement gegen den ringförmigen Hülsenboden, so dass eine zuverlässige Abdichtung über das Dichtelement erreicht ist.

Vorzugsweise ist dabei der Radialsteg Teil der Unterziehhülse, an den sich ein Hülsenschaft anschließt, mit dem die Unterziehhülse zwischen dem Kabelmantel der Versorgungsleitung und dem Klemmelement einliegt. Hierdurch ist eine besonders zuverlässig und effektive Schirmkontaktierung erzielt.

In zweckdienlicher Ausgestaltung liegt im Anschlussraum des Gehäuses ein Isolatorelement ein, welches insbesondere als ein separates, eigenständiges Bauteil ausgebildet ist. Bei diesem handelt es sich insbesondere um ein Spritzgussteil. Dieses Isolatorelement umgibt dabei eine Verbindungsstelle zwischen der eingehenden und der ausgehenden Versorgungsleitung.

Das Isolatorelement besteht dabei vorzugsweise aus mehreren Teilen, beispielsweise einem Basiskörper sowie einem Verschlussteil hierzu, so dass bei geöffnetem Isolatorelement die Versorgungsleitungen in einfacher Weise eingelegt und anschließend durch Aufbringen des Verschlussteils sicher im Isolatorelement eingeschlossen werden können. Die beiden Teile des Isolatorelements werden dabei beispielsweise durch Schnappverbindungen miteinander verbunden.

Zweckdienlicherweise ist dabei das Isolatorelement insgesamt derart geformt, dass es zumindest bereichsweise zum Innengehäuse eine komplementäre Form annimmt. Die Form ist dabei derart gewählt, dass das Isolatorelement insgesamt formschlüssig im Innengehäuse einliegt und durch diesen Formschluss in zumindest eine Richtung, vorzugsweise in alle Richtungen fixiert ist.

Insbesondere ist hierzu vorgesehen, dass das Innengehäuse in Teilbereichen eine Auswölbung oder eine Einbuchtung aufweist und komplementär hierzu das Isolatorelement eine Einbuchtung bzw. Auswölbung. Zweckdienlicherweise ist das Isolatorelement hierbei sowohl in Leitungslängsrichtung als auch senkrecht hierzu von den beiden Schalterteilen des Innengehäuses formschlüssig gehalten. Insgesamt ist dadurch das Isolatorelement ortsfest an definierter Position fixiert. Durch das Isolatorelement sind die Verbindungs- und Kontaktstellen zwischen den beiden Versorgungsleitungen geschützt und insbesondere zuverlässig gegeneinander isolierend getrennt. Auch eine isolierende Trennung zu dem ebenfalls leitenden Innengehäuse ist dadurch ebenfalls zuverlässig erzielt.

Ein Ausführungsbeispiel wird nachfolgend anhand der Figuren näher erläutert. Darin zeigen:
- FIG 1: eine perspektivische Ansicht auf einen Hochvolt-Leistungsverteiler, der in Querrichtung geschnitten ist,
- FIG 2: eine Aufsicht auf den Leistungsverteiler gemäß FIG 1, bei dem die oberen Gehäuseschalen abgenommen sind,
- FIG 3: eine perspektivische Explosionsdarstellung eines Außengehäuses des Verteilergehäuses des Leistungsverteilers,
- FIG 4: eine ausschnittsweise vergrößerte Schnittdarstellung im Bereich einer Gehäusedurchführung mit darin einliegender Versorgungsleitung,
- FIG 5: eine ausschnittsweise Schnittansicht einer Versorgungsleitung mit einer endseitig daran angebrachten Schirmhülsen-Baugruppe,
- FIG 6: eine perspektivische Aufsicht auf einen Leistungsverteiler gemäß einer zweiten Variante mit geöffnetem Gehäuse,
- FIG 7: ein Teil des Gehäuses mit einem einliegenden Isolatorelement des Leistungsverteiler nach Fig. 6 sowie
- FIG 8: eine ausschnittsweise Schnittdarstellung im Bereich einer Gehäusedurchführung gemäß einer zweiten Variante.

In den Figuren sind gleichwirkende Teile mit den gleichen Bezugszeichen versehen.

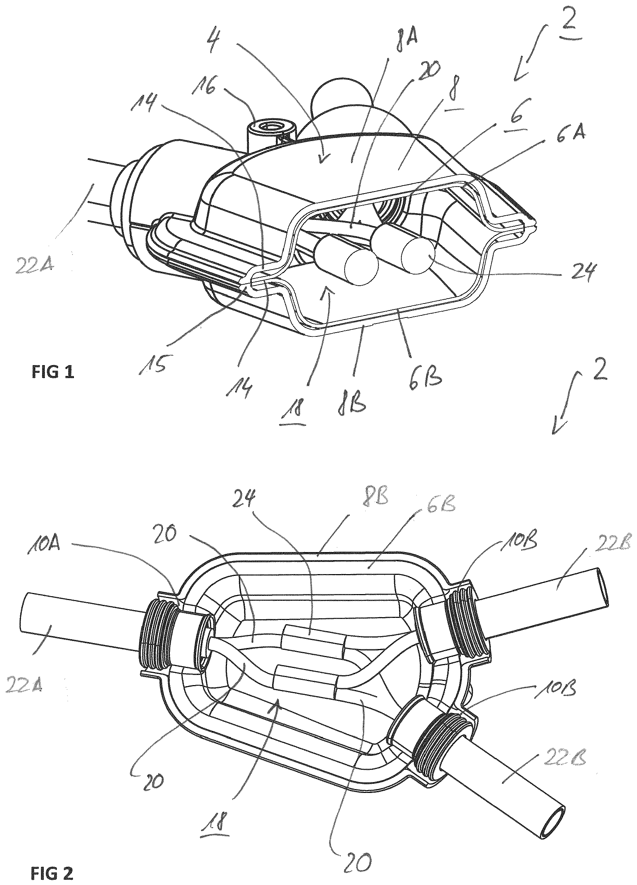

Der in den FIG 1 und 2 dargestellte Hochvolt-Leistungsverteiler 2 umfasst ein Verteilergehäuse 4, welches ein Innengehäuse 6 sowie ein dieses schalenartig umgebendes Außengehäuse 8 aufweist. Die beiden Gehäuse 6, 8 selbst sind wiederum jeweils durch zwei Halbschalen gebildet, nämlich jeweils eine Oberschale 6A, 8A sowie eine Unterschale 6B, 8B. Die beiden Halbschalen 6A, 6B des Innengehäuses 6 sind als gebogene Blechteile ausgebildet und bilden zusammen ein vollständig geschlossenes metallisches Innengehäuse 6, welches lediglich an Gehäusedurchführungen 10A, 10B offen ist. Das Innengehäuse 6 wird von dem Außengehäuse 8 vollständig umschlossen, wobei das Außengehäuse 8 die Kontur des Innengehäuses 6 nachbildet, sich daher im Wesentlichen an das Innengehäuse 6 anschmiegt. Das Außengehäuse 8 ist aus einem nicht leitfähigen Material, insbesondere aus Kunststoff ausgebildet. Die Halbschalen 8A, 8B sind dabei insbesondere als Spritzguss-Teile ausgebildet. Durch die isolierende Eigenschaft des Außengehäuses ist auch eine elektrische Isolierung des Innengehäuses 6 gegenüber der Umgebung gewährleistet, so dass auch entsprechende sicherheitstechnische Anforderungen im Hinblick beispielsweise auf einen Berührschutz eingehalten sind.

Der Leistungsverteiler 2 ist insgesamt im Ausführungsbeispiel nach Art eines Y-Verteilers ausgebildet. Grundsätzlich sind auch andere Verteilerformen, beispielsweise eine T-förmige oder eine Kammförmige Ausgestaltungen möglich. Der Leistungsverteiler 2 weist an seiner einen Stirnseite eine eingangsseitige Gehäusedurchführung 10A sowie an der gegenüberliegenden Stirnseite zwei ausgangsseitige Gehäusedurchführungen 10B auf. Im Bereich der Gehäusedurchführungen 10A. 10B bildet zumindest das Außengehäuse 8 Durchführstutzen aus.

Die Halbschalen 6A, 6B sowie 8A, 8B weisen jeweils einen umlaufenden, sich in einer Horizontal- und Trennungsebene erstreckenden Rand 14 auf. Die Oberschale 6A liegt mit ihrem Rand 14 flächig auf dem entsprechenden Rand 14 der Unterschale 6B des Innengehäuses 6 auf. Die Ränder 14 des Außengehäuses 8 klemmen quasi diesen Randbereich des Innengehäuses 6 zwischen sich ein. Die Gehäuseschalen 6A, 6B, 8A, 8B werden durch geeignete Befestigungsmittel aneinander befestigt. Im Ausführungsbeispiel erfolgt dies über Schraubbefestigungen. Hierzu weist das Außengehäuse 8 Schraubdome 16 auf, in die Befestigungsschrauben im montierten Zustand eingeführt sind.

Wie insbesondere aus der FIG 1 zu entnehmen ist, weist der Rand 14 umfangsseitig einen Dichtrand 15 auf, der den Rand 14 des Innengehäuses 6 übersteht, so dass das Innengehäuse 6 vollumfänglich eingeschlossen ist. Die beiden Halbschalen 8A, 8B des Außengehäuses 8 liegen mit ihrem Dichtrand 15 aufeinander dichtend auf. Bei Bedarf kann zwischen den Dichträndern 15 noch ein zusätzliches Dichtelement eingebracht sein.

Das Innengehäuse 6 definiert innerhalb der gebogenen Halbschalen 6A, 6B einen Anschlussraum 18, in den Leitungsadern 20 von Versorgungsleitungen 22A, 22B eingeführt und miteinander über ein Verbindungselement 24 elektrisch verbunden sind. Im Ausführungsbeispiel wird eine eingangsseitige Versorgungsleitung 22A an zwei ausgangseitige Versorgungsleitungen 22B angeschlossen. Im Beispiel ist jeweils eine zweiadrige Versorgungsleitung 22A, 22B mit zwei Leitungsadern 20 dargestellt, wobei jede Leitungsader 20 der eingehenden Versorgungsleitung 22A mit jeweils einer Leitungsader 20 einer jeweiligen ausgehenden Versorgungsleitung 22B verbunden ist. Das Verbindungselement 24 ist beispielsweise als ein Crimpelement oder auch ein Schweißkontaktelement ausgebildet.

Die Versorgungsleitungen 22A, B weisen neben der Leitungsader 20 jeweils eine diese umgebende Innenisolierung 26, eine diese wiederum umgebende Abschirmung 28 sowie schließlich einen außenseitigen Kabelmantel 30 auf. Die Abschirmung 28 ist insbesondere als ein metallisches Abschirmgeflecht ausgebildet.

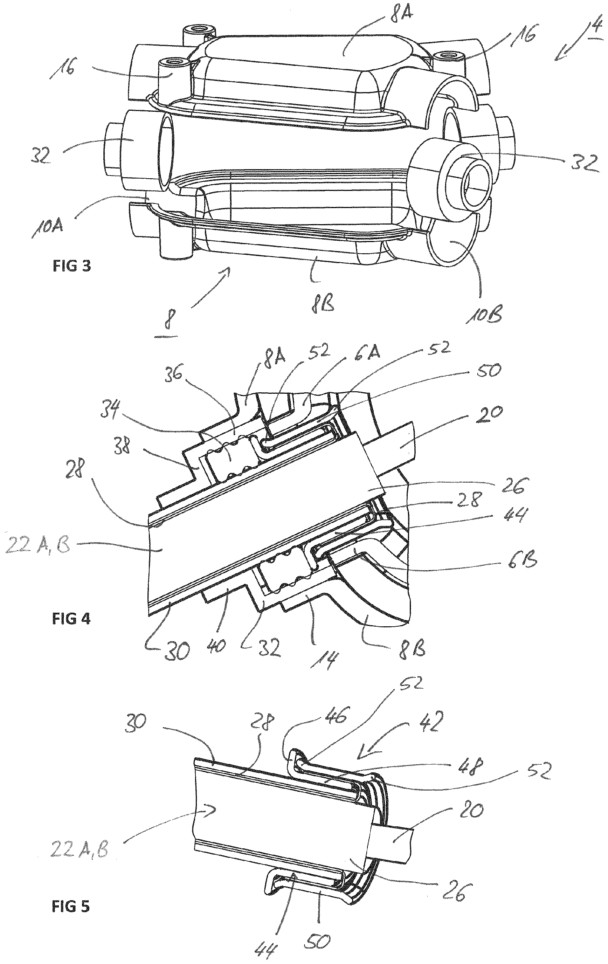

Zur abgedichteten Einführung der Versorgungsleitungen 22A, 22B in den Anschlussraum 18 ist eine zweiteilige Dichtungsanordnung in eine jeweilige Gehäusedurchführung 10A, 10B eingelegt. Und zwar besteht diese im Ausführungsbeispiel aus einer Dichtungshülse 32, die ein Dichtelement 34 aufnimmt, wie dies insbesondere anhand der FIG 4 zu entnehmen ist.

Die Dichtungshülse 32 definiert hierbei eine topfförmige Aufnahme, in der das Dichtelement 34 einliegt. Sie weist einen sich in Kabellängsrichtung erstreckenden zylindrischen Hohlschaft 36 auf, welcher an seiner dem Anschlussraum 18 abgewandten Seite an einen ringförmigen Hülsenboden 38 anschließt. An diesem schließt sich wiederum ein hülsenförmiger Ringsteg 40 an. Insgesamt ist daher die Dichtungshülse 32 im Querschnitt betrachtet stufenförmig ausgebildet, wobei sich der Hohlschaft 36 und der Ringsteg 40 in Kabellängsrichtung und der Hülsenboden 38 in einer hierzu senkrechten Querrichtung erstreckt. Der Ringsteg 40 Liegt dabei dichtend am Kabelmantel 30 an. Gleichzeitig liegt der Hohlschaft 36 mit seiner Außenseite an der Innenseite der jeweiligen Gehäusedurchführung 10A, 10B am Außengehäuse 8 an.

Das Dichtelement 34 ist wiederum zwischen der Innenseite des Hülsenschafts 36 und dem Kabelmantel 30 eingeklemmt, so dass eine zuverlässige Abdichtung erzielt ist. Wie aus FIG 4 zu entnehmen ist, ist das Dichtelement 34 insgesamt als ein Dichtring ausgebildet, welcher sowohl an seiner Innenseite als auch an seiner Außenseite wellenartig mit einzelnen Erhebungen und Senkungen ausgebildet ist, so dass einzelne Dichtstege gebildet sind. Das Dichtelement 34 besteht aus einem geeigneten Dichtmaterial, beispielsweise Silikon. Das Material der Dichthülse 32 ist vorzugsweise hierzu verschieden und insbesondere auf eine zuverlässige Abdichtung zum Außengehäuse 8 abgestimmt.

Alternativ zu der dargestellten Dichtungsanordnung ist das Dichtelement unmittelbar zwischen dem Kabelmantel 30 und der Innenwandung der jeweiligen Gehäusedurchführung 10A, 10B also zwischen dem Kabelmantel 30 und dem Verteilergehäuse 4, insbesondere dem Außengehäuse 8, angeordnet.

Insbesondere bei dieser Ausgestaltung ist über die jeweilige einen Einführstutzen bildende Gehäusedurchführung 10A, 10B eine Verschlusskappe aus Isoliermaterial gestülpt, die am Verteilergehäuse 4 beispielsweise durch eine Verrastung gesichert ist und die weiterhin vorzugsweise rückseitig am Kabelmantel 30 insbesondere zur Gewährleistung einer Zugentlastung fixiert ist. Zur Fixierung weist beispielsweise die Verschlusskappe rückseitig einen Halte- und Fixiersteg auf, welcher sich in Axialrichtung erstreckt und nur teilweise um den Kabelmantel 30 umläuft. Um diesen Haltesteg ist ein Fixierelement, wie beispielsweise ein Kabelbinder geführt.

Das metallische Innengehäuse 6 dient insgesamt zur EMV-Abschirmung des Verbindungsbereichs im Anschlussraum 18. Um eine durchgehende Abschirmung zu erzielen ist eine sichere elektrische Kontaktierung des Innengehäuses 6 mit der jeweiligen Abschirmung 28 der Versorgungsleitungen 22A, B erforderlich. Um diese zu gewährleisten ist eine Schirmhülsen-Baugruppe 42 an einer jeweiligen Versorgungsleitung 22A, B befestigt, wie insbesondere aus FIG 5 oder aus FIG 4 zu entnehmen ist.

Die Schirmhülsen-Baugruppe 42 umfasst eine Unterziehhülse 44, welche einen sich in Querrichtung erstreckenden Radialsteg 46 sowie einen sich in Kabellängsrichtung erstreckenden Hülsenschaft 48 aufweist. Die Unterziehhülse 44 liegt mit dem Hülsenschaft 48 am Kabelmantel 30 an. Der Radialsteg 46 steht in radialer Richtung ab und schließt im montierten Zustand zum Hülsenboden 38 einen Aufnahmeraum ein, in dem das Dichtelement 34 einliegt.

Weiterhin umfasst die Schirmhülsen-Baugruppe 42 eine Crimphülse 50, welche von außen unter Zwischenlage der Abschirmung 28 mit dem Hülsenschaft 48 vercrimpt, also auf diesem aufgeklemmt ist. Dadurch wird eine sichere und zuverlässige Kontaktierung zwischen der Abschirmung 28 zur Crimphülse 50 erreicht. Die Crimphülse 50 ist schließlich mit dem Innengehäuse 6 elektrisch leitend verbunden. Hierzu weist die Crimphülse 50 an ihren Stirnseiten beispielsweise jeweils abgebogene Federzungen auf, mit denen die Crimphülse 50 gegen den Rand 40 der jeweiligen Halbschale 6A, 6B des Innengehäuses 6 gepresst ist. Insgesamt wird bei der Montage beim Verspannen der beiden Schalen 8A, 8B des Außengehäuses 8 die beiden Halbschalen 6A, 6B des Innengehäuses 6 gegen die Crimphülse 50 verspannt, um eine zuverlässige elektrische Kontaktierung zu gewährleisten.

Wie insbesondere aus Fig. 4 sowie Fig. 5 zu erkennen ist, weist die Crimphülse beidendseitig einen aufgebördelten umlaufenden Rand 52 auf. Die Halbschalen 6A,6B bilden als Gehäusedurchführung 10A, 10B einen Einführstutzen aus, der sich in Einführ- oder Axialrichtung erstreckt. Dieser wird nach außen durch einen äußeren Stirnrand und nach innen durch einen innere Gehäuseaufweitung begrenzt ist. Die Crimphülse 50 ist in ihrem Mittenbereich zwischen den beiden Rändern 52 von diesem Einführstutzen, also von den beiden Halbschalen 6A, 6B geklemmt. Die Ränder 52 umgreifen dabei jeweils formschlüssig den Einführstutzen an seinen beiden Enden und liegen an diesen unmittelbar an. Dadurch ist die Schirmhülsen-Baugruppe 42 unverschiebbar in der jeweiligen Gehäusedurchführung 10A, 10B gehalten.

Weiterhin dient die Schirmhülsen-Baugruppe 42 durch ihre Ausbildung auch zur Zugentlastung der jeweiligen Versorgungsleitung 22A,22B. Eine wirksame Zugentlastung ist hierbei insbesondere durch die axiale Fixierung der Schirmhülsen-Baugruppe 42 am Innengehäuse 6 einerseits und ihre kraft- und vorzugsweise auch formschlüssige Verbindung mit dem Kabelmantel 30 erzielt. Infolge des Crimpens wird der Kabelmantel 30 vorzugsweise verformt, so dass ein in axialer Richtung wirkender Formschluss mit dem Kabelmantel 30 ausgebildet ist.

Bei der Montage wird wie folgt vorgegangen: Die jeweiligen miteinander zu verbindenden Versorgungsleitungen 22A, 22B werden stirnendseitig abisoliert. Hierbei wird die jeweilige Leitungsader 20 freigelegt. Der Kabelmantel 30 wird in einem Teilbereich entfernt, ohne dass die Abschirmung 28 durchtrennt wird. Anschließend wird die Unterziehhülse 44 über den Kabelmantel 30 geschoben, bevor die Abschirmung 28 um etwa 180° umgeschlagen wird, so dass sie auf der Umfangsseite des Hülsenschafts 48 um Aufliegen kommt. Anschließend wird die Crimphülse 50 über den Hülsenschaft 48 gestülpt und anschließend mit diesem durch einen Crimpprozess verklemmt.

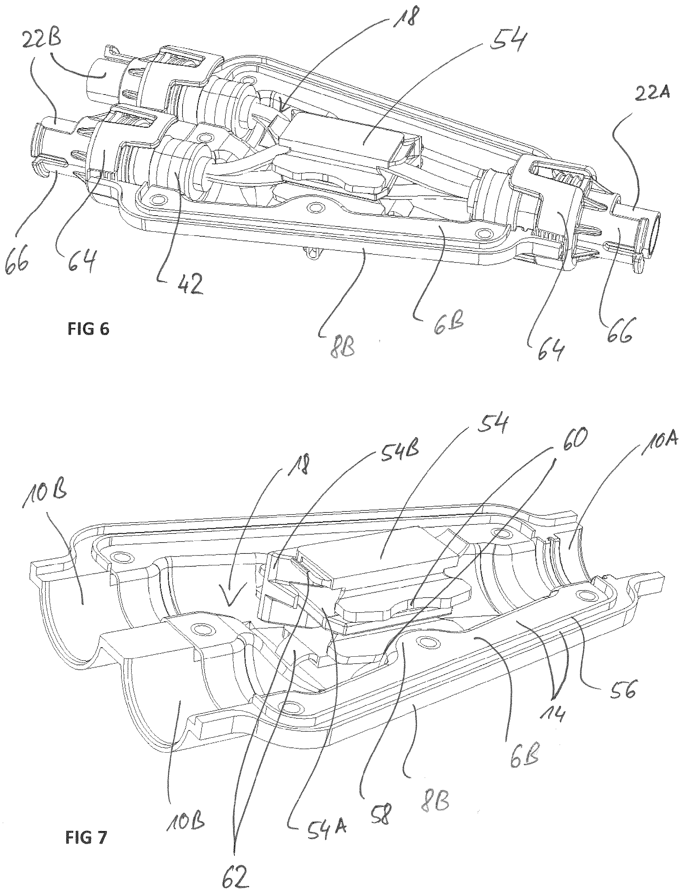

In den Fig. 6 bis 8 ist eine zweite Ausführungsvariante des Leistungsverteilers 2 dargestellt. Wie insbesondere aus den Fig. 6 und 7 hervorgeht, zeichnet sich diese zweite Variante insbesondere durch die Anordnung eines zusätzlichen Isolatorelements 54 aus. Innerhalb dieses Isolatorelements 54 erfolgt die elektrisch leitende Verbindung zwischen den eingehenden Versorgungsleitungen 22A und den ausgehenden Versorgungsleitungen 22B. Ein weiteres Unterscheidungsmerkmal betrifft die Ausbildung im Bereich der Gehäusedurchführungen 10A, 10B.

Die Ausbildung des Verteilergehäuses 4 mit dem Innengehäuse 6 sowie dem Außengehäuse 8 ist dabei zu der ersten Ausführungsvariante im Wesentlichen unverändert und insofern wird auf diese Bezug genommen. Das Innengehäuse 6 besteht daher wiederum aus zwei Blechschalen 6A,6B, die beispielsweise als Tiefziehelemente ausgebildet sind und die zwischen sich einen vollständig geschlossenen Anschlussraum 18 einschließen, welcher einen freien Innenhohlraum definiert.

Aus der Darstellung der Fig. 7 ist nochmals zu erkennen, dass die Schalen 6A,6B; 8A,8B der beiden Gehäuse 6,8 schalenartig ineinander einliegen. Die Schalen 8A,8B des Außengehäuses weisen daher die gleiche Kontur wie die Schalen 6A,6B des Innengehäuses auf, schmiegen sich also an diese Schalen 6A,6B unmittelbar an. Bei der Ausführungsvariante gemäß den Fig. 6 und 7 weist der umlaufende Rand 14 weiterhin einen Begrenzungssteg 56 auf, an dem die Außenkontur des ebenfalls umlaufenden Rands 14 des Innengehäuses 6 formschlüssig einliegt, so dass dieses also ortsfest fixiert ist.

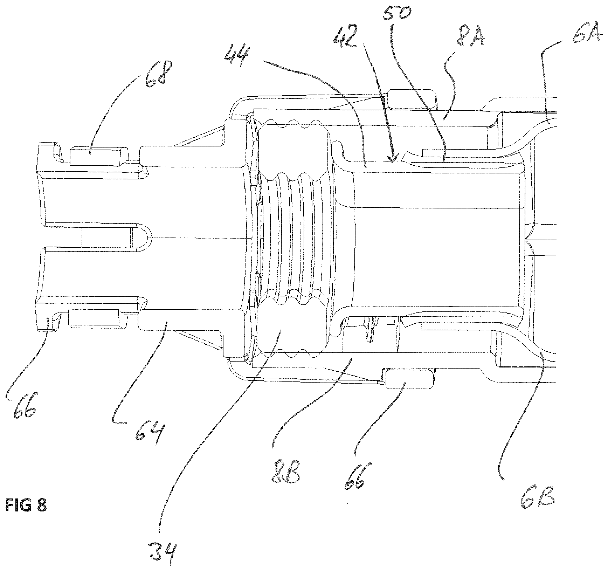

Aus der Darstellung der Fig. 7 ist weiterhin gut zu erkennen, dass die Gehäusedurchführungen 10A, 10B nach Art von Stutzen ausgebildet sind. Dabei weist jedes der Schalenteile 6A,6B; 8A,8B jeweils einen Halbstutzen auf. Dabei überstehen die Stutzen des Außengehäuses 8 die des Innengehäuses 6 in Richtung der Versorgungsleitungen 22A,22B. Wie insbesondere auch aus Fig. 6 sowie auch der Querschnittsdarstellung der Fig. 8 zu entnehmen ist, liegt das Dichtelement 34, welches als Ringdichtung ausgebildet ist, in dem überstehenden Stutzenbereich des Außengehäuses 8 ein. Gleichzeitig ist die Schirmhülsen-Baugruppe 42 zumindest teilweise auch im Bereich des Stutzens des Innengehäuses 6 angeordnet und innerhalb dieses Stutzens eingeklemmt. Wie insbesondere aus der Fig. 8 zu entnehmen ist, ist hierzu das Innengehäuse 6, also die jeweilige Schale 6A,6B, zur Ausbildung des Stutzens radial etwas nach innen eingezogen und eingebogen. In diesem Stutzenbereich wird dabei eine radiale Anpress- und Klemmkraft auf die Schirmhülsen-Baugruppe 42 übertragen, so dass diese innerhalb dieses Stutzens zuverlässig geklemmt ist. Über die radiale Klemmung wird hierbei eine besonders gute elektrische und dauerhaft zuverlässige Kontaktierung zwischen der hier in der Fig. 8 nicht dargestellten Abschirmung 28, der Schirmhülsen-Baugruppe 42 und dem Innengehäuse 26 erzielt.

In Fig. 8 ist aus Gründen der Übersicht auf die Darstellung der Versorgungsleitung 22A,22B verzichtet.

Das Isolatorelement 54 besteht im Ausführungsbeispiel aus zwei Elementen, nämlich einem Grundkörper 54A, und einem Deckelteil 54B, die miteinander verrastet sind. Der Grundkörper 54A bildet dabei Kammern aus, die zwei getrennte Aufnahmeräume für die zu verbindenden Versorgungsleitungen 22A,22B definieren. Die Versorgungsleitungen 22A,22B können daher in einfacher Weise in diese Kammern eingelegt werden. Nach dem Einlegen verschließt das Deckelteil 54B die Kammern, so dass die Kontaktierungsstellen beispielsweise mit dem Vebindungselement 24 innerhalb dieser Kammern voneinander isolierend getrennt angeordnet sind.

Im Ausführungsbeispiel sind dabei die Kammern senkrecht zur Erstreckungsrichtung der Versorgungsleitungen 22A,22B übereinander angeordnet. Das Isolatorelement 54 ist innerhalb des Innengehäuses 6 ortsfest fixiert. Hierzu ist das Isolatorelement 54 vorzugsweise formschlüssig mit dem Innengehäuse 6 verbunden. Zweckdienlicherweise wird dabei sowohl in Erstreckungsrichtung der Versorgungsleitung 22A,22B als auch senkrecht hierzu ein Formschluss mit den Schalen 6A, 6B ausgebildet.

Zur Ausbildung des Formschlusses in Erstreckungsrichtung weist im Ausführungsbeispiel das Innengehäuse 6, also jede der beiden Schalen 6A,6B, eine randseitige Auswölbung 58a auf, die in eine entsprechende Ausmuldung 60 des Isolatorelements 54 eingreift. Hierzu weist das Isolatorelement 54 randseitig überstehende Bereiche auf. Das Isolatorelement 54 ist dabei zweckdienlicherweise an jeder Seite mit jedem der beiden Gehäuseschalen 6A,6B formschlüssig verbunden und weist insbesondere für jede Schale 6A,6B an einer Randseite eine derartige Ausmuldung 60 auf. Die formschlüssige Verbindung liegt an beiden gegenüberliegenden Seiten des Isolatorelements 54 vor.

Zur Fixierung des Isolatorelements 54 senkrecht zur Längserstreckung weist das Isolatorelement jeweils nach oben bzw. nach unten zu den Schalen 6A,6B abgebogene Laschen 62 auf. Diese greifen entweder in entsprechend ausgebildete Ausnehmungen oder stützen sich an den Schalen 6A,6B elastisch ab.

Wie insbesondere aus den Fig. 6 und 8 zu entnehmen ist, ist im Bereich der Gehäusedurchführungen 10A, 10B jeweils ein Kappenelement 64 ausgebildet, durch welches die jeweilige Versorgungsleitung 22A,22B hindurchgeführt ist. Bei dem Kappenelement handelt es sich um ein Kunststoffelement, welches einerseits die jeweilige Versorgungsleitung 22A,22B hülsenförmig umgibt und andererseits den jeweiligen Gehäusestutzen des Außengehäuses 8. Über das Kappenelement 64 erfolgt unter anderem auch eine Zugentlastung. Hierzu ist das Kappenelement 64 einerseits mit der jeweiligen Versorgungsleitung 22A,22B und andererseits mit dem Außengehäuse 8 fixiert. Die Fixierung mit dem Außengehäuse 8 erfolgt bevorzugt über eine Schnappverbindung mit Hilfe von Rastelementen.

Zur Fixierung der Versorgungsleitung 22A,22B weist das Kappenelement 64 ein Befestigungsstück 66 auf, welches nur für einen begrenzten Winkelbereich umlaufend ausgebildet ist. Im Bereich dieses Befestigungsstücks 66 ist in der montierten Endstellung ein Fixierelement 68 angeordnet, beispielsweise ein Kabelbinder (vgl. Fig. 8), welcher an dieser Stelle die Versorgungsleitung 22A,22B mit dem Befestigungsstück 66 verklemmt.

Insgesamt ist durch den hier beschriebenen Leistungsverteiler 2 eine Leistungsverteilung von einer eingehenden Versorgungsleitung 22A auf mehrere ausgehende Versorgungsleitungen 22B erzielt, wobei zuverlässig eine elektrische EMV-Abschirmung sowie eine Abdichtung gegenüber der Umwelt erreicht ist. Der Leistungsverteiler 2 zeichnet sich dabei durch einen einfachen und robusten Aufbau mit dem Verteilergehäuse 4 aus.

Der Leistungsverteiler 2 ist im endmontierten Zustand in einem Fahrzeug angeordnet, welches insbesondere als Elektro- oder Hybridfahrzeug mit einem elektromotorischen Fahrmotor ausgestattet ist.

### Bezugszeichenliste

- 2: Leistungsverteiler
- 4: Verteilergehäuse
- 6: Innengehäuse
- 8: Außengehäuse
- 6A, 8A: Oberschale
- 6B, 8B: Unterschale
- 10A: eingangsseitige Gehäusedurchführung
- 10B: ausgangsseitige Gehäusedurchführung
- 14: Rand
- 15: Dichtrand
- 16: Schraubdom
- 18: Anschlussraum
- 20: Leitungsader
- 22A: eingehende Versorgungsleitung
- 22B: ausgehende Versorgungsleitung
- 24: Verbindungselement
- 26: Innenisolierung
- 28: Abschirmung
- 30: Kabelmantel
- 32: Dichtungshülse
- 34: Dichtelement
- 36: Hohlschaft
- 38: Hülsenboden
- 40: Ringsteg
- 42: Schirmhülsen-Baugruppe
- 44: Unterziehhülse
- 46: Radialsteg
- 48: Hülsenschaft
- 50: Crimphülse
- 52: Rand
- 54: Isolatorelement
- 54A: Grundkörper
- 54B: Deckelteil
- 56: Begrenzungssteg
- 58: Auswölbung
- 60: Ausmuldung
- 62: Lasche
- 64: Kappenelement
- 66: Befestigungsstück
- 68: Fixierelement

## Patentansprüche

1. Elektrischer Leistungsverteiler (2) für ein Elektro- oder Hybridfahrzeug mit elektromotorischem Fahrantrieb, umfassend ein Verteilergehäuse (4) mit einem Anschlussraum (18), In dem zumindest eine eingehende Versorgungsleitung (22A) an zumindest zwei abgehende Versorgungsleitungen (22B) angeschlossen ist, wobei die Versorgungsleitungen (22A, 22B) jeweils durch eine Gehäusedurchführung (10A, 10B) in den Anschlussraum (18) eingeführt sind und wobei das Verteilergehäuse (4) einen zweiteiligen Aufbau aufweist mit einem den Anschlussraum (18) umgebenden Innengehäuse (6) aus zwei Schalen (6A, 6B) aus einem elektrisch leitfähigen Material und mit einem Außengehäuse (8) aus einem elektrisch isolierenden Material, in dem das Innengehäuse (6) schalenartig einliegt, wobei eine jeweilige Abschirmung der Versorgungsleitungen (22A, 22B) jeweils elektrisch leitend mit dem Innengehäuse (6) verbunden ist, wobei die Abschirmung (28) elektrisch mit einer Schirmhülsen-Baugruppe (42) kontaktiert ist, welche mit dem Innengehäuse (6) elektrisch verbunden ist und wobei die Schirmhülsen-Baugruppe (42) in der jeweiligen, Gehäusedurchführung (10A, 10B) in axialer Richtung durch einen in beide Richtungen wirkenden Formschluss mit dem Innengehäuse (6) fixiert ist, **dadurch gekennzeichnet, dass** die Schirmhülsen-Baugruppe (42) eine Unterziehhülse (44) sowie ein als Hülse (50) ausgebildetes Klemmelement aufweist und die Abschirmung (28) zwischen der Unterziehhülse (44) und dem Klemmelement eingeklemmt ist, wobei das Innengehäuse zur Ausbildung der jeweiligen Gehäusedurchführung (10A, 10B) jeweils einen Stutzen aufweist, in denen die Schirmhülsen-Baugruppe (42) eingeklemmt ist und wobei die Schirmhülsen-Baugruppe (42) dadurch in der jeweiligen, Gehäusedurchführung (10A, 10B) in axialer Richtung fixiert ist, dass zumindest eine der Hülsen (44,50) einen in axialer Richtung wirkenden Formschluss mit dem Innengehäuse (6) ausbildet und hierzu radial an beiden Enden zur Ausbildung eines in beide Richtungen wirkenden Formschlusses aufgeweitet ist.

2. Leistungsverteiler (2) nach Anspruch 1, bei dem das Innengehäuse (6) ein Blechgehäuse ist.

3. Leistungsverteiler (2) nach einem der vorhergehenden Ansprüche, bei dem das Innengehäuse (6) bis auf die Gehäusedurchführungen (10A, 10B) vollständig geschlossen ausgebildet ist.

4. Leistungsverteiler (2) nach einem der vorhergehenden Ansprüche, bei dem das Außengehäuse (8) durch Umspritzen des Innengehäuses (6) oder durch separate Halbschalen (8A, 8B) ausgebildet ist.

5. Leistungsverteiler (2) nach einem der vorhergehenden Ansprüche, bei dem das Außengehäuse (8) und das Innengehäuse (6) jeweils aus zwei Halbschalen (6A, 6B; 8A, 8B) mit einem umlaufenden Rand (14) gebildet sind, wobei vorzugsweise der Rand des Innengehäuses (6) zwischen den Halbschalen (8A, 8B) des Außengehäuses (8) einliegt.

6. Leistungsverteiler (2) nach einem der vorhergehenden Ansprüche, bei dem eine jeweilige Versorgungsleitung (22A, 22B) jeweils durch ein in einer Dichtungshülse (32) einliegendes Dichtelement (34) durch die jeweilige Gehäusedurchführung (10A, 10B) geführt ist.

7. Leistungsverteiler (2) nach Anspruch 6, bei dem die Dichtungshülse (32) topfförmig ausgebildet ist.

8. Leistungsverteiler (2) nach einem der vorhergehenden Ansprüche, bei dem die Schirmhülsen-Baugruppe (42) in der jeweiligen Gehäusedurchführung (10A, 10B) eingeklemmt ist.

9. Leistungsverteiler (2) nach einem der vorhergehenden Ansprüche, bei dem die Hülse als Crimphülse (50) ausgebildet ist.

10. Leistungsverteiler (2) nach einem der Ansprüche 6 bis 9, bei dem die Schirmhülsen-Baugruppe (42) einen Radialsteg (46) aufweist, welcher das Dichtelement (34) in Richtung zu einem Hülsenboden (38) der Dichtungshülse (32) einschließt.

11. Leistungsverteiler (2) nach dem vorhergehenden Anspruch, bei dem das Dichtelement (34) zwischen dem Hülsenboden (38) und dem Radialsteg (46) eingepresst ist.

12. Leistungsverteiler (2) nach dem vorhergehenden Anspruch, bei dem die Unterziehhülse (44) den Radialsteg (46) sowie einen Hülsenschaft (48) aufweist, mit dem sie zwischen einem Mantel der Versorgungsleitung (22A, 22B) und dem Klemmelement einliegt.

13. Leistungsverteiler (2) nach einem der Ansprüche 11 bis 13, bei dem das Klemmelement den beidendseitig aufgeweiteten Rand aufweist wobei zwischen diesen Rändern die jeweilige stutzenförmige Gehäusedurchführung (10A, 10B) anliegt.

14. Leistungsverteiler (2) nach einem der vorhergehenden Ansprüche, bei dem in dem Anschlussraum (18) ein insbesondere mehrteiliges Isolatorelement (54) einliegt, in dem die eingehende Versorgungsleitung (22A) mit der ausgehenden Versorgungsleitung (22B) verbunden ist.

15. Leistungsverteiler (2) nach dem vorhergehenden Anspruch, bei dem das Isolatorelement (54) als ein separates Formelement ausgebildet ist mit einer zumindest bereichsweise zum Innengehäuse (6) komplementären Form, so dass das Isolatorelement (54) formschlüssig im Innengehäuse (6) fixiert ist.

## Claims

1. Electrical power distributor (2) for an electric or hybrid vehicle having electromotive drive, comprising a distributor housing (4) having a connection space (18) in which at least one incoming supply line (22A) is connected to at least two outgoing supply lines (22B), wherein the supply lines (22A, 22B) are respectively introduced through a housing feedthrough (10A, 10B) into the connection space (18) and wherein the distributor housing (4) has a two-part structure having an inner housing (6) which encloses the connection space (18) and which is formed of two shells (6A, 6B) made from an electrically conductive material and having an outer housing (8) made from an electrically insulating material in which the inner housing (6) is enclosed in a shell-like manner, wherein a respective shielding of the supply lines (22A, 22B) is respectively connected to the inner housing (6) in an electrically conductive manner,
wherein
the shielding (28) is electrically contacted with a shielding sleeve assembly (42) which is electrically connected to the inner housing (6) and wherein the shielding sleeve assembly (42) is fixed in the axial direction in the respective housing feedthrough (10A, 10B) by means of a positive connection to the inner housing (6) acting in both directions, **characterised in that**
the shielding sleeve assembly (42) has an under-sleeve (44) and a clamping element which is formed as a sleeve (50) and the shielding (28) is clamped between the under-sleeve (44) and the clamping element, wherein the inner housing has one respective connection piece for the formation of each housing feedthrough (10A, 10B), in which connection piece the shielding sleeve assembly (42) is clamped and wherein the shielding sleeve assembly (42) is fixed in the axial direction in the respective housing feedthrough (10A, 10B) in such a way that at least one of the sleeves (44, 50) forms a positive connection to the inner housing (6) which acts in the axial direction and for this purpose is widened radially on both ends for the formation of a positive connection acting in both directions.

2. Electrical power distributor (2) according to claim 1, wherein the inner housing (6) is a sheet metal housing.

3. Electrical power distributor (2) according to one of the preceding claims, wherein the inner housing (6) is formed to be completely closed except for the housing feedthroughs (10A, 10B).

4. Electrical power distributor (2) according to one of the preceding claims, wherein the outer housing (8) is formed by overmoulding the inner housing (6) or by separate half shells (8A, 8B).

5. Electrical power distributor (2) according to one of the preceding claims, wherein the outer housing (8) and the inner housing (6) are respectively formed of two half shells (6A, 6B; 8A, 8B) having a peripheral edge (14), wherein the edge of the inner housing (6) is preferably enclosed between the half shells (8A, 8B) of the outer housing (8).

6. Electrical power distributor (2) according to one of the preceding claims, wherein a respective supply line (22A, 22B) is respectively guided through a sealing element (34) enclosed in a sealing sleeve (32) through the respective housing feedthrough (10A, 10B).

7. Electrical power distributor (2) according to claim 6, wherein the sealing sleeve (32) is formed to be pot shaped.

8. Electrical power distributor (2) according to one of the preceding claims, wherein the shielding sleeve assembly (42) is clamped in the respective housing feedthrough (10A, 10B).

9. Electrical power distributor (2) according to one of the preceding claims, wherein the sleeve is formed as a crimp sleeve (50).

10. Electrical power distributor (2) according to one of claims 6 to 9, wherein the shielding sleeve assembly (42) has a radial web (46) which encloses the sealing element (34) in the direction of a sleeve base (38) of the sealing sleeve (32).

11. Electrical power distributor (2) according to the preceding claim, wherein the sealing element (34) is pressed in between the sleeve base (38) and the radial web (46).

12. Electrical power distributor (2) according to the preceding claim, wherein the under-sleeve (44) has the radial web (46) and a sleeve shaft (48) with which it is enclosed between a sheath of the supply line (22A, 22B) and the clamping element.

13. Electrical power distributor (2) according to one of claims 11 to 13, wherein the clamping element has the edge which is widened at both end sides, wherein the respective connection piece-like housing feedthrough (10A, 10B) lies between these edges.

14. Electrical power distributor (2) according to one of the preceding claims, wherein an in particular multi-part insulator element (54) is enclosed in the connection space (18), wherein the incoming supply line (22A) is connected to the outgoing supply line (22B).

15. Electrical power distributor (2) according to the preceding claim, wherein the insulator element (54) is formed as a separate form element having a form which is complementary, at least in regions, to the inner housing (6) such that the insulator element (54) is fixed in the inner housing (6) by means of a positive connection.

## Revendications

1. Répartiteur de puissance électrique (2) pour un véhicule électrique ou hybride avec un entraînement de marche à moteur électrique, comprenant un boitier de répartiteur (4) avec une chambre de raccordement (18) dans laquelle au moins un câble d'alimentation entrant (22A) est raccordé à au moins deux câbles d'alimentation sortants (22B),
dans lequel les câbles d'alimentation (22A, 22B) sont menés chacun par l'intermédiaire d'une traversée de boitier (10A, 10B), à l'intérieur de la chambre de raccordement (18), et
dans lequel le boitier de répartiteur (4) présente un mode de construction en deux parties avec un boitier intérieur (6) en deux coques (6A, 6B) en un matériau électriquement conducteur, qui entoure la chambre de raccordement (18), et un boitier extérieur (8) en un matériau isolant sur le plan électrique, dans lequel est logé à la manière d'une coque, le boitier intérieur (6), dans lequel un blindage respectif des câbles d'alimentation (22A, 22B) est relié respectivement de manière électriquement conductrice au boitier intérieur (6),
dans lequel le blindage (28) est en contact électrique avec un module de douilles de blindage (42), qui est relié électriquement au boitier intérieur (6),
et dans lequel le module de douilles de blindage (42) est fixé au boitier intérieur (6), dans la direction axiale, dans la traversée de boitier (10A, 10B) respective, par une liaison par complémentarité de formes agissant dans les deux directions,
**caractérisé**
**en ce que** le module de douilles de blindage (42) comprend une douille sous-jacente (44) ainsi qu'un élément de serrage réalisé sous forme de douille (50), et le blindage (28) est enserré entre la douille sous-jacente (44) et l'élément de serrage, le boitier intérieur présentant, pour former la traversée de boitier (10A, 10B) respective, un embout respectif dans lequel est enserré le module de douilles de blindage (42), et le module de douilles de blindage (42) étant fixé, dans la direction axiale, dans la traversée de boitier (10A, 10B) respective, par le fait que l'une au moins des douilles (44, 50) forme avec le boitier intérieur (6), une liaison par complémentarité de formes agissant dans la direction axiale, et est à cet effet évasée radialement aux deux extrémités pour former une liaison par complémentarité de formes agissant dans les deux directions.

2. Répartiteur de puissance (2) selon la revendication 1, dans lequel le boitier intérieur (6) est un boitier en tôle.

3. Répartiteur de puissance (2) selon l'une des revendications précédentes, dans lequel le boitier intérieur (6) est d'une configuration totalement fermée exception faite des traversées de boitier (10A, 10B).

4. Répartiteur de puissance (2) selon l'une des revendications précédentes, dans lequel le boitier extérieur (8) est réalisé par surmoulage du boitier intérieur (6) ou par des demi-coques (8A, 8B) séparées.

5. Répartiteur de puissance (2) selon l'une des revendications précédentes, dans lequel le boitier extérieur (8) et le boitier intérieur (6) sont formés chacun de deux demi-coques (6A, 6B; 8A, 8B) possédant une bordure périphérique (14), la bordure du boitier intérieur (6) étant de préférence insérée entre les demi-coques (8A, 8B) du boitier extérieur (8).

6. Répartiteur de puissance (2) selon l'une des revendications précédentes, dans lequel chaque câble d'alimentation (22A, 22B) respectif est mené à travers la traversée de boitier (10A, 10B) respective en passant respectivement dans un élément d'étanchéité (34) placé dans une douille d'étanchéité (32).

7. Répartiteur de puissance (2) selon la revendication 6, dans lequel la douille d'étanchéité (32) est réalisée sous forme de coupelle.

8. Répartiteur de puissance (2) selon l'une des revendications précédentes, dans lequel le module de douilles de blindage (42) est enserré dans la traversée de boitier (10A, 10B) respective.

9. Répartiteur de puissance (2) selon l'une des revendications précédentes, dans lequel la douille est réalisée sous forme de douille à sertir (50).

10. Répartiteur de puissance (2) selon l'une des revendications 6 à 9, dans lequel le module de douilles de blindage (42) présente une collerette radiale (46), qui enferme l'élément d'étanchéité (34) en direction d'un fond de douille (38) de la douille d'étanchéité (32).

11. Répartiteur de puissance (2) selon la revendication précédente, dans lequel l'élément d'étanchéité (34) est pressé entre le fond de douille (38) et la collerette radiale (46).

12. Répartiteur de puissance (2) selon la revendication précédente, dans lequel la douille sous-jacente (44) présente la collerette radiale (46) ainsi que le corps de douille (48) avec lequel elle s'insère entre une enveloppe du câble d'alimentation (22A, 22B) et l'élément de serrage.

13. Répartiteur de puissance (2) selon l'une des revendications 11 à 13, dans lequel l'élément de serrage présente, des deux côtés, la bordure évasée, et entre ces bordures s'appuie la traversée de boitier (10A, 10B) en forme d'embout, respective.

14. Répartiteur de puissance (2) selon l'une des revendications précédentes, dans lequel à l'intérieur de la chambre de raccordement (18) est logé un élément formant isolateur (54), notamment en plusieurs parties, à l'intérieur duquel le câble d'alimentation entrant (22A) est relié au câble d'alimentation sortant (22B).

15. Répartiteur de puissance (2) selon la revendication précédente, dans lequel l'élément formant isolateur (54) est réalisé en tant qu'élément de forme moulé, séparé, présentant, au moins par endroits, une forme complémentaire au boitier intérieur (6), de sorte que l'élément formant isolateur (54) se trouve ainsi fixé par complémentarité de formes, dans le boitier intérieur (6).
